# EUROPEAN PATENT SPECIFICATION

(11) **EP 3 892 577 B1**
(45) Date of publication and mention of the grant of the patent: **01.06.2022**
(21) Application number: 20168628.4
(22) Date of filing: 08.04.2020
(51) Int. Cl.: B66B 1/34

(54) **ELEVATOR CONTROL CABINET AND METHOD FOR INSTALLATION OF AN ELECTRICAL APPARATUS INTO AN ELEVATOR CONTROL CABINET**
AUFZUGSSTEUERUNGSSCHRANK UND VERFAHREN ZUR INSTALLATION EINES ELEKTRISCHEN GERÄTS IN EINEN AUFZUGSSTEUERUNGSSCHRANK
ARMOIRE DE COMMANDE D'ASCENSEUR ET PROCÉDÉ D'INSTALLATION D'UN APPAREIL ÉLÉCTRIQUE DANS UNE ARMOIRE DE COMMANDE D'ASCENSEUR

(43) Date of publication of application: 13.10.2021
(73) Proprietor: KONE Corporation, 00330 Helsinki (FI)
(72) Inventor: Kauppinen, Tuukka, 00330 Helsinki (FI); Hämäläinen, Matti, 00330 Helsinki (FI); Paakkinen, Mikko, 00330 Helsinki (FI)
(74) Representative: Kolster Oy Ab

(56) References cited:
- CN-U- 204 310 618
- CN-U- 207 185 001
- CN-U- 207 312 849

## Description

### BACKGROUND OF THE INVENTION

### FIELD OF THE INVENTION

This invention relates to an elevator control cabinet and to a method for installation of an electrical apparatus into an elevator control cabinet.

### DESCRIPTION OF PRIOR ART

In order to operate an elevator a significant number of electrical devices are needed. A common solution is to utilize an elevator control cabinet where many of these electrical devices are installed. Previously, elevator control cabinets are known from CN -U - 204310618, CN - U - 207185001 and CN - U 207312849, for instance.

An example of an electrical apparatus that needs special attention is an electrical drive supplying power to an electrical motor. The electrical drive may comprise a power converter, such as a frequency converter.

A problem relating to this electrical apparatus is the weight. Especially in high speed and high-rise elevators, power converters are large and heavy, possibly 100 kg or more. Installation of such an electric apparatus into an elevator control cabinet may require a considerable amount of manpower.

### SUMMARY OF THE INVENTION

An object of the present invention is to solve the above-mentioned drawback and to provide a solution which simplifies assembly work and maintenance work. This object is achieved with an elevator control cabinet according to independent claim 1 and a method for installation of an electrical apparatus into an elevator control cabinet according to independent claim 9.

When a pair of rails and a pair of rollers are arranged to the cabinet and the electrical apparatus, it becomes possible to hoist the electrical apparatus to a position where the rollers can be arranged onto the rails, and the electrical apparatus can be transferred into its final position in the cabinet by means of the rollers. This significantly simplifies the assembly and maintenance work.

Preferred embodiments of the invention are disclosed in the dependent claims.

### BRIEF DESCRIPTION OF DRAWINGS

In the following the present invention will be described in closer detail by way of example and with reference to the attached drawings, in which
Figure 1 illustrates an elevator control cabinet,
Figures 2 and 3 illustrate an electrical apparatus, and
Figures 4A to 4D illustrate a method for installation of an electrical apparatus into an elevator control cabinet.

### DESCRIPTION OF AT LEAST ONE EMBODIMENT

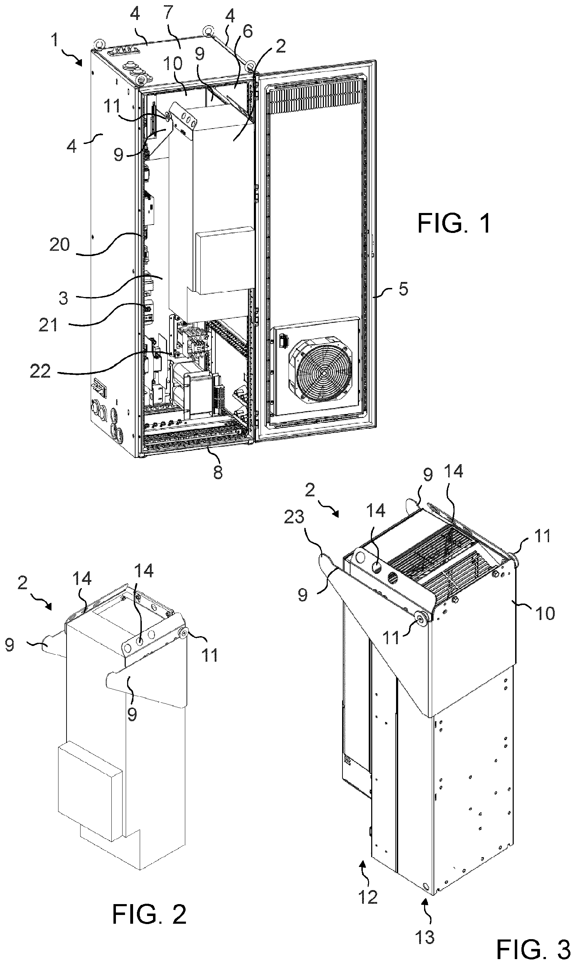

Figure 1 illustrates an elevator control cabinet 1 and Figures 2 and 3 illustrate an illustrate an electrical apparatus 2 which in Figure 1 is mounted in place into the cabinet 1. Figure 2 illustrates a front view of the electrical apparatus 2 and Figure 3 a back view.

The cabinet 1 provides a space 3 for installation of electrical devices. This space is delimited by walls 4 and 5, which in the illustrated example are laterally orientated, by a roof 7 and possibly by a bottom 8. In the illustrated example one of the side walls 4 and 5 is implemented as a door 5 which in a closed position covers an access opening 6 into the space 3. This access space is provided in the front wall of the cabinet. Instead of a hinged door, the access opening 6 may be covered by a removable cover, for instance. In this example, the door 5 and also the access opening 6 has a height substantially corresponding to the height of the cabinet 1. Alternatively, it is possible that the access opening 6 has a height substantially smaller than the height of the cabinet 1. In that case a part of the front wall of the cabinet may be fixedly attached to the cabinet, while the door 5 or the removable cover have a height covering only the front part of the cabinet where the access opening 6 is provided, for instance.

In addition to the electrical apparatus 2, the space 3 of the cabinet 1 may additionally contain other devices needed for operating an elevator, such as a brake control 20, contactors 21 or power sources 22.

A pair of rails 9 are attached to one or more of the walls 4 to extend towards the access opening 6. In Figure 1 the rails 9 are attached to a back wall of the cabinet by means of a common plate 10. The rails 9 and the common plate 10 are illustrated also in Figures 2 and 3, though they are not a part of the electrical apparatus, but in praxis attached to one or more of the walls of the cabinet.

The electrical apparatus comprises a pair of rollers 11 in a back part 13 of and on opposite sides of the electrical apparatus 2. While the electrical apparatus is mounted into the cabinet, the rollers 11 contact the pair of rails 9 such that the rails, via the rollers carry at least a part of the weight of the electrical apparatus 2, as illustrated in Figure 1. In this connection the front part 12 of the electrical apparatus 2 refers to the part of the electrical apparatus 2 that faces the access opening 6 (once mounted into the cabinet) while the back part 13 is on the opposite side as compared to the front part and faces away from the access opening towards a back wall of the cabinet. Once mounted, the back part 13 may contact the back wall of the cabinet to facilitate that the electrical apparatus 2 can be attached to the back wall 4 of the cabinet 1 by screws or bolts, for instance.

The electrical apparatus 2 is additionally provided with at least one lifting element 14 in an upper part of the electrical apparatus 2. This lifting element 14 is provided at a location closer to the front part 12 than the pair of rollers 11. In praxis this lifting element 14 may be implemented as a loop, hook or hole in a part of the electrical apparatus, for instance. In the illustrated example, two lifting elements 14 have been provided as two holes in plates extending upwards on opposite sides of the electrical apparatus.

Via the lifting element 14, or lifting elements, the electrical apparatus can be hoisted to a position illustrated in Figure 1, where the pair of rollers 11 are located on a respective top surface of the rails 9. In this position the chain, wire or line used for hoisting via the lifting elements 14 has been removed, and the rails 9 carry the weight of the electrical apparatus 2 via the rollers 11. In order to prevent that the rollers 11 roll forward past the front ends of the rails 9, the rails are provided with stopper elements 23 in the front end of the rails, which are located closest to the access opening 6. In praxis one stopper element may be sufficient. The stopper element or stopper elements 23 may be implemented by shaping the upwardly facing surfaces of the rails 9 that contact the rollers 11 in such a way, that these surfaces which are generally horizontally orientated, have an outer part protruding upwards such that the rollers are unable to pass the outer ends by accident.

The electrical apparatus 2 illustrated in the figures may be an electrical drive for supplying power to an electrical motor, for instance. The electrical drive may comprise a power converter, such as a frequency converter. With the illustrated design, such an electrical apparatus, which may weight more than 100 kg can be easily be mounted into the cabinet and also removed from the cabinet. This job can be done by one single person alone.

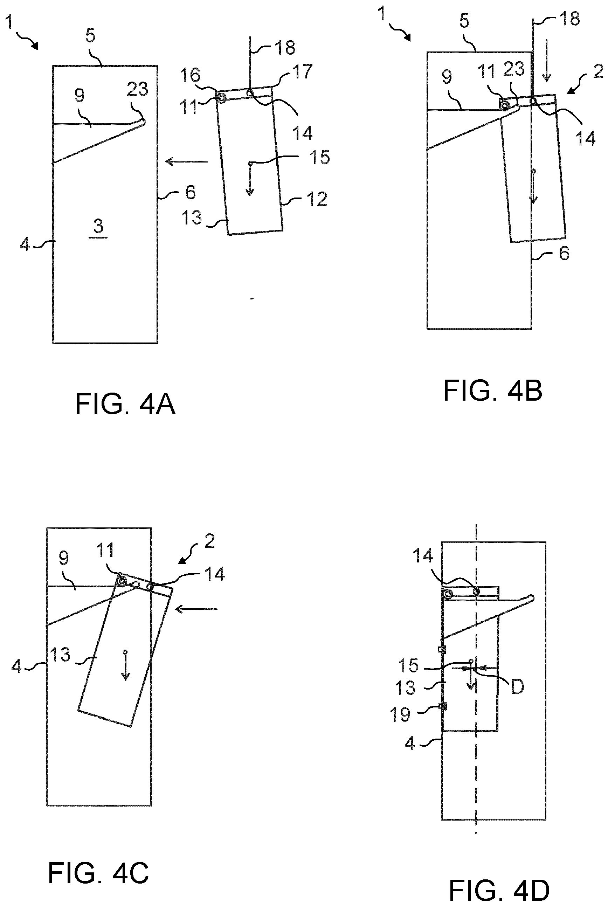

Figures 4A to 4D illustrate a method for installation of an electrical apparatus into an elevator control cabinet. This method can be utilized for the cabinet 1 and electrical apparatus 2 illustrated in Figures 1 to 3.

In Figure 4A the electrical apparatus 2 is hoisted by a chain 18 (or alternatively a wire or line, for instance) which is attached to the lifting element 14 or lifting elements. At this stage the electrical apparatus 2 is transferred in a horizontal direction towards the access opening 6 of the cabinet 1.

In this embodiment, though not necessarily in all implementations, the lifting element 14 utilized for hoisting is located in such a position in relation to the center of gravity 15 of the electrical apparatus 2 that an upper surface of the electrical apparatus is inclined in relation to the horizontal plane while the entire weight of the electrical apparatus 2 is carried by the lifting element. In praxis, the upper edge 16 of the back part 13 which is closest to the access opening 6, is located lower than the upper edge 17 in the front part 12, as illustrated in Figure 4A. An advantage with this is that it is easier to hoist the electrical apparatus 2 into a position where the rollers 11 are located above the rails 9, as the risk that the electrical apparatus collides with the roof 7 of the cabinet 1 is minimized. Such an inclination of the upper surface of the electrical apparatus (and of the entire electrical apparatus) is obtained by locating the center of gravity 15 closer to the back part 13 of the electrical apparatus than the at least one lifting element 14. This is illustrated in Figure 4D where the electrical apparatus is in its upright position that it obtains once installed in the cabinet. In this position the center of gravity is closer to the back part 13 with a distance D as compared to the lifting element 14.

Figure 4B illustrates the electrical apparatus 2 in a position where the back part 13 protrudes into the cabinet 1 via the access opening 6. At this stage the rollers 11 are arranged over the pair of rails 9 and the electrical cabinet 2 is lowered until the rails 9 via the rollers carry the weight of the electrical apparatus. As can be seen from Figure 4B, the stopper element 23, the lifting element 14 and the pair of rollers 11 are mutually arranged in such locations that the lifting element 14 is located outside of the cabinet 1 space when the pair of rollers 11 are located on the rails 9 and contact the stopper element 23. Due to these mutual locations, the chain 18 used for hoisting the electrical apparatus 2 can still at this stage be connected to the lifting element 14 and carry a part of the weight of the electrical apparatus 2 without damaging the roof 7.

In Figure 4C, the chain 18 has been removed from the lifting element 14, and the entire weight of the electrical apparatus 2 is carried by the rails 9 via the rollers 11. In this position the electrical apparatus 2 slides into position in the cabinet. Due to the rollers 11 rotating on the upper surface of the rails 9, the force needed to push the electrical apparatus 2 into its final position is low enough for one person to alone push the electrical apparatus into its final position.

In Figure 4D the electrical apparatus 2 has reached its final position in the cabinet. Due to contact between the back part 13 of the electrical apparatus 2 and the back wall 4 of the cabinet 1, the electrical apparatus has obtained an upright position as illustrated in Figure 4D. At this stage the electrical apparatus can be attached to the cabinet by means of screws or bolts 19, for instance.

It is to be understood that the above description and the accompanying figures are only intended to illustrate the present invention. It will be obvious to a person skilled in the art that the invention can be varied and modified without departing from the scope of the appended claims.

## Claims

1. An elevator control cabinet (1) wherein
the elevator control cabinet (1) provides a space (3) which is enclosed by walls (4, 5) and a roof (7),
one of the walls (4, 5) consists entirely or partly of a removable cover or a door covering an access opening (6) into the space (3),
an electrical apparatus (2) is provided in the space (3), the electrical apparatus has a front part (12) facing the access opening (6) and a back part (13)
facing away from the access opening (6), **characterized in that**
a pair of rails (9) are attached to one or more of the walls (4) to extend towards the access opening (6),
the electrical apparatus (2) comprises a pair of rollers (11) arranged in the back part (13) of the electrical apparatus (2) and on opposite sides of the electrical apparatus (2) to contact the pair of rails (9) which via the pair of rollers (11) carry at least a part of the weight of the electrical apparatus (2),
at least one lifting element (14) is provided in an upper part of the electrical apparatus (2) at a location closer to the front part (12) than said pair of rollers (11), said at least one lifting element (14) providing an attachment point for hoisting the electrical apparatus (2).

2. The elevator control cabinet according to claim 1, wherein the pair of rails (9) comprise a generally horizontal upwardly facing surface providing a base for the pair of rollers (11) to roll on during installation and removal of the electrical apparatus (2) from the elevator control cabinet (1).

3. The elevator control cabinet according to claim 1 or 2, wherein at least one rail in the pair or rails (9) is provided with an upwardly protruding stopper element (23) in a front end of the rail, which front end is located closest to the access opening (6).

4. The elevator control cabinet according to claim 1, wherein the stopper element (23), the at least one lifting element (14) and the pair of rollers (11) are mutually arranged in such locations that the lifting element (14) is located outside of the space (3) when the pair of rollers (11) is located on the pair of rails (9) and contact the stopper element (23).

5. The elevator control cabinet according to one of claims 1 to 4, wherein said electrical apparatus (2) is an electrical drive for supplying power to an electrical motor.

6. The elevator control cabinet according to one of claims 1 to 5, wherein the electrical apparatus (2) comprises a center of gravity (15) located closer to the back part (13) of the electrical apparatus (2) than the at least one lifting element (14) when the electrical apparatus is attached to the elevator control cabinet (1).

7. The elevator control cabinet according to one of claims 1 to 6, wherein the elevator control cabinet (1) is provided with screws or bolts (19) attaching the electrical apparatus (2) to one or more of the walls (4).

8. The elevator control cabinet according to one of claims 1 to 7, wherein the space additionally contains a brake control (20), contactors (21) or power sources (22) for controlling operation of an elevator.

9. A method for installation of an electrical apparatus into an elevator control cabinet, **characterized in that** the method comprises
hoisting the electrical apparatus (2), via at least one lifting element (14) located in an upper part of the electrical apparatus (2) and closer to a front part (12) than to a back part (13) of the electrical apparatus (2), to a position where at least the back part (13) of the electrical apparatus protrudes into the elevator control cabinet (1) via an access opening (6) of the elevator control cabinet,
arranging a pair of rollers (11) provided on the back part (13) of the electrical apparatus (2) over a pair of rails (9) which in the elevator control cabinet protrude towards the access opening (6),
lowering the electrical apparatus (2) such that the pair of rails (9) via the pair of rollers (11) carry the weight of the electrical apparatus,
sliding the electrical apparatus (2) into position in the elevator control cabinet by means of the pair of rollers (11) which rotate along the pair of rails (9) inwardly into the elevator control cabinet.

10. The method according to claim 9, wherein the electrical apparatus (2) is attached by screws or bolts (19) to one or more walls (4) of the cabinet.

## Patentansprüche

1. Aufzugssteuerschrank (1), wobei
der Aufzugssteuerschrank (1) einen Raum (3) bereitstellt, der von Wänden (4, 5) und einem Dach (7) umschlossen ist,
eine der Wände (4, 5) ganz oder teilweise aus einer abnehmbaren Abdeckung oder einer Tür besteht, die eine Zugangsöffnung (6) zum Raum (3) verdeckt,
eine elektrische Vorrichtung (2) in dem Raum (3) bereitgestellt ist, wobei die elektrische Vorrichtung einen der Zugangsöffnung (6) zugewandten vorderen Teil (12) und einen von der Zugangsöffnung (6) abgewandten hinteren Teil (13) aufweist, **dadurch gekennzeichnet, dass**
ein Paar von Schienen (9) an einer oder mehreren der Wände (4) befestigt ist, die sich in Richtung der Zugangsöffnung (6) erstrecken,
die elektrische Vorrichtung (2) ein Paar von Rollen (11) umfasst, die im hinteren Teil (13) der elektrischen Vorrichtung (2) und auf gegenüberliegenden Seiten der elektrischen Vorrichtung (2) angeordnet sind, um das Paar von Schienen (9) zu berühren, die über das Paar von Rollen (11) zumindest einen Teil des Gewichts der elektrischen Vorrichtung (2) tragen,
mindestens ein Hubelement (14) in einem oberen Teil der elektrischen Vorrichtung (2) an einer Stelle bereitgestellt ist, die näher an dem vorderen Teil (12) liegt als das Paar von Rollen (11), wobei das mindestens eine Hubelement (14) einen Befestigungspunkt zum Anheben der elektrischen Vorrichtung (2) bereitstellt.

2. Aufzugssteuerschrank nach Anspruch 1, wobei das Paar von Schienen (9) eine im Allgemeinen horizontale, nach oben weisende Oberfläche aufweist, die eine Basis für das Paar von Rollen (11) bildet, auf welcher diese während des Einbauens und des Ausbauens der elektrischen Vorrichtung (2) aus dem Aufzugssteuerschrank (1) rollen können.

3. Aufzugssteuerschrank nach Anspruch 1 oder 2, wobei mindestens eine Schiene des Paares von Schienen (9) mit einem nach oben vorstehenden Anschlagelement (23) an einem vorderen Ende der Schiene versehen ist, das der Zugangsöffnung (6) am nächsten liegt.

4. Aufzugssteuerschrank nach Anspruch 1, wobei das Anschlagelement (23), das mindestens eine Hubelement (14) und das Paar von Rollen (11) an solchen Stellen angeordnet sind, dass sich das Hubelement (14) außerhalb des Raums (3) befindet, wenn sich das Paar von Rollen (11) auf dem Paar von Schienen (9) befindet und das Anschlagelement (23) berührt.

5. Aufzugssteuerschrank nach einem der Ansprüche 1 bis 4, wobei die elektrische Vorrichtung (2) ein elektrischer Antrieb zur Versorgung eines Elektromotors ist.

6. Aufzugssteuerschrank nach einem der Ansprüche 1 bis 5, wobei die elektrische Vorrichtung (2) einen Schwerpunkt (15) aufweist, der näher am hinteren Teil (13) der elektrischen Vorrichtung (2) liegt als das mindestens eine Hubelement (14), wenn die elektrische Vorrichtung am Aufzugssteuerschrank (1) angebracht ist.

7. Aufzugssteuerschrank nach einem der Ansprüche 1 bis 6, wobei der Aufzugssteuerschrank (1) mit Schrauben oder Bolzen (19) versehen ist, die die elektrische Vorrichtung (2) an einer oder mehreren der Wände (4) befestigen.

8. Aufzugssteuerschrank nach einem der Ansprüche 1 bis 7, wobei der Raum zusätzlich eine Bremssteuerung (20), Schütze (21) oder Stromquellen (22) zur Steuerung des Betriebs eines Aufzugs enthält.

9. Verfahren zum Einbau einer elektrischen Vorrichtung in einen Aufzugssteuerschrank, **dadurch gekennzeichnet, dass** das Verfahren umfasst
Anheben der elektrischen Vorrichtung (2), über mindestens ein Hubelement (14), das sich in einem oberen Teil des elektrischen Vorrichtung (2) und näher an einem vorderen Teil (12) als an einem hinteren Teil (13) der elektrischen Vorrichtung (2) befindet, in eine Position, in der zumindest der hintere Teil (13) der elektrischen Vorrichtung durch eine Zugangsöffnung (6) des Aufzugssteuerschranks in den Aufzugssteuerschrank (1) hineinragt,
Anordnen eines Paares von Rollen (11), die am hinteren Teil (13) der elektrischen Vorrichtung (2) vorgesehen sind, über einem Paar von Schienen (9), die in dem Aufzugssteuerschrank in Richtung der Zugangsöffnung (6) vorstehen,
Absenken der elektrischen Vorrichtung (2), so dass das Paar von Schienen (9) über das Paar von Rollen (11) das Gewicht der elektrischen Vorrichtung trägt,
Einschieben der elektrischen Vorrichtung (2) in den Aufzugssteuerschrank mit Hilfe des Paares von Rollen (11), das sich entlang des Paares von Schienen (9) rollend nach innen in den Aufzugssteuerschrank bewegt.

10. Verfahren nach Anspruch 9, wobei die elektrische Vorrichtung (2) mit Schrauben oder Bolzen (19) an einer oder mehreren Wänden (4) des Schranks befestigt ist.

## Revendications

1. Armoire de commande d'ascenseur (1), dans laquelle :
l'armoire de commande d'ascenseur (1) fournit un espace (3) qui est enfermé par les parois (4, 5) et un toit (7),
l'une des parois (4, 5) se compose entièrement ou partiellement d'un couvercle amovible ou d'une porte recouvrant une ouverture d'accès (6) dans l'espace (3),
un appareil électrique (2) est prévu dans l'espace (3), l'appareil électrique a une partie avant (12) faisant face à l'ouverture d'accès (6) et une partie arrière (13) orientée à l'opposé de l'ouverture d'accès (6), **caractérisée en ce que** :
une paire de rails (9) sont fixés à une ou plusieurs des parois (4) pour s'étendre vers l'ouverture d'accès (6),
l'appareil électrique (2) comprend une paire de rouleaux (11) agencés dans la partie arrière (13) de l'appareil électrique (2) et sur les côtés opposés de l'appareil électrique (2) pour être en contact avec la paire de rails (9) qui, via la paire de rouleaux (11), porte au moins une partie du poids de l'appareil électrique (2),
au moins un élément de levage (14) est prévu dans une partie supérieure de l'appareil électrique (2) à un emplacement plus à proximité de la partie avant (12) que ladite paire de rouleaux (11), ledit au moins un élément de levage (14) fournissant un point de fixation pour lever l'appareil électrique (2).

2. Armoire de commande d'ascenseur selon la revendication 1, dans laquelle la paire de rails (9) comprend une surface orientée vers le haut généralement horizontale fournissant une base pour la paire de rouleaux (11) afin de rouler pendant l'installation et le retrait de l'appareil électrique (2) de l'armoire de commande d'ascenseur (1).

3. Armoire de commande d'ascenseur selon la revendication 1 ou 2, dans laquelle au moins un rail dans la paire de rails (9) est prévu avec un élément de butée en saillie vers le haut (23) dans une extrémité avant du rail, laquelle extrémité avant est positionnée le plus à proximité de l'ouverture d'accès (6).

4. Armoire de commande d'ascenseur selon la revendication 1, dans laquelle l'élément de butée (23), le au moins un élément de levage (14) et la paire de rouleaux (11) sont agencés mutuellement dans des emplacements tels que l'élément de levage (14) est positionné à l'extérieur de l'espace (3) lorsque la paire de rouleaux (11) est positionnée sur la paire de rails (9) et est en contact avec l'élément de butée (23).

5. Armoire de commande d'ascenseur selon l'une des revendications 1 à 4, dans laquelle ledit appareil électrique (2) est un entraînement électrique pour fournir l'énergie à un moteur électrique.

6. Armoire de commande d'ascenseur selon l'une des revendications 1 à 5, dans laquelle l'appareil électrique (2) comprend un centre de gravité (15) positionné plus à proximité de la partie arrière (13) de l'appareil électrique (2) que le au moins un élément de levage (14) lorsque l'appareil électrique est fixé sur l'armoire de commande d'ascenseur (1).

7. Armoire de commande d'ascenseur selon l'une des revendications 1 à 6, dans laquelle l'armoire de commande d'ascenseur (1) est prévue avec des vis ou des boulons (19) fixant l'appareil électrique (2) à une ou plusieurs des parois (4) .

8. Armoire de commande d'ascenseur selon l'une des revendications 1 à 7, dans laquelle l'espace contient de plus une commande de frein (20), des contacteurs (21) ou des sources d'énergie (22) pour commander le fonctionnement d'un ascenseur.

9. Procédé pour installer un appareil électrique dans une armoire de commande d'ascenseur, **caractérisé en ce que** le procédé comprend les étapes suivantes :
lever l'appareil électrique (2), via au moins un élément de levage (14) positionné dans une partie supérieure de l'appareil électrique (2) et plus à proximité d'une partie avant (12) que d'une partie arrière (13) de l'appareil électrique (2), dans une position dans laquelle au moins la partie arrière (13) de l'appareil électrique fait saillie dans l'armoire de commande d'ascenseur (1) via une ouverture d'accès (6) de l'armoire de commande d'ascenseur,
agencer une paire de rouleaux (11) prévue sur la partie arrière (13) de l'appareil électrique (2) sur une paire de rails (9) qui, dans l'armoire de commande d'ascenseur, fait saillie vers l'ouverture d'accès (6),
abaisser l'appareil électrique (2) de sorte que la paire de rails (9), via la paire de rouleaux (11), porte le poids de l'appareil électrique,
faire coulisser l'appareil électrique (2) en position dans l'armoire de commande d'ascenseur au moyen de la paire de rouleaux (11) qui tourne le long de la paire de rails (9) vers l'intérieur dans l'armoire de commande d'ascenseur.

10. Procédé selon la revendication 9, dans lequel l'appareil électrique (2) est fixé par des vis ou des boulons (19) sur une ou plusieurs parois (4) de l'armoire.
